# EUROPÄISCHE PATENTSCHRIFT

(11) **EP 0 617 851 B1**
(45) Veröffentlichungstag und Bekanntmachung des Hinweises auf die Patenterteilung: **22.11.1995**
(21) Anmeldenummer: 93902017.8
(22) Anmeldetag: 28.01.1993
(51) Int. Cl.: H01R 9/00

(54) **STECKVERBINDER FÜR ELEKTRONIK-LEITERPLATTEN**
FLAT-PIN CONNECTOR FOR ELECTRONIC CIRCUIT BOARDS
CONNECTEUR A FICHES POUR PLAQUETTES DE CIRCUITS IMPRIMES ELECTRONIQUES

(30) Priorität: 14.09.1992 CH 2883/92
(43) Veröffentlichungstag der Anmeldung: 05.10.1994
(73) Patentinhaber: MELCHER AG, CH-8610 Uster (GB)
(72) Erfinder: GAMMENTHALER, Peter, CH-8335 Hittnau (CH)
(74) Vertreter: Salgo, Reinhold Caspar, Dr.
(86) Internationale Anmeldenummer: CH9300022
(87) Internationale Veröffentlichungsnummer: WO9407281

(56) Entgegenhaltungen:
- CH-A- 656 024
- DE-A- 1 665 757
- DE-B- 2 115 438
- DE-B- 2 210 991

## Beschreibung

Die vorliegende Erfindung betrifft eine Messerleiste zum Einbau in 19-Zoll-Baugruppenträger nach dem Oberbegriff des Patentanspruches 1.

Ein Steckverbinder besteht aus einer sog. Messerleiste und ihrem Gegenstück, der Federleiste. Solche Feder- und Messerleisten sind bekannt und weitverbreitet im Einsatz. Zur Rationalisierung von Konstruktion und Produktion sind sie genormt worden, so z.B. unter der Norm DIN 41 612. Zusammen mit der Normung der Leiterplatten, der Gehäuse und der Baugruppenträger mit dem dazugehörigen Teilungsraster (DIN 41 494) ergibt sich ein genormtes System, welches sich als sehr tauglich erwiesen hat.

Die Konstruktionsmerkmale der Messerleisten sind von zwei Seiten her bestimmt: Von der Seite der Messerkontakte her (Kontaktseite), welche dimensionell mit den entsprechenden Federleisten übereinstimmen müssen, und von der Seite der an der Messerleiste befestigten elektronischen Baugruppen her, die zumeist auf Leiterplatten aufgebaut sind (Leiterplattenseite).

Sehr bewährt hat sich die Norm für Messerleisten als Basis für eine offene Leiterplatte zum Einschub in einen l9-Zoll-Baugruppenträger.

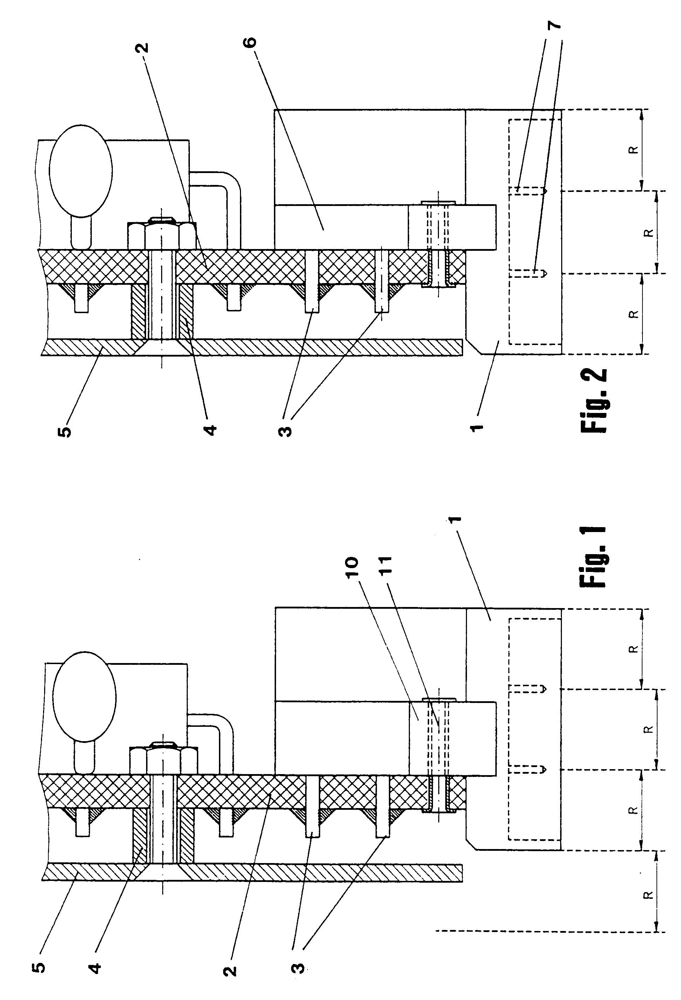

Soll eine Leiterplatte noch eine Abschirmplatte tragen oder in ein Gehäuse (Kassette) eingebaut werden, so erweist es sich, dass die von verschiedenen Herstellern angebotenen und durchgenormten Messerleisten optimale Lösungen erschweren. Bei der Entwicklung von modernen Elektronik-Geräten besteht oft die Forderung nach minimalem Platzbedarf, das bedeutet, dass der durch den Teilungsraster gegebene Raum bestmöglich ausgenützt werden muss. Dabei haben sich solche auf dem Markt erhältlichen und normierten Messerleisten als hinderlich erwiesen. Diese Behinderungen werden im Zusammenhang mit Fig. 1 näher erläutert.

Die Aufgabe der vorliegenden Erfindung ist es, eine Messerleiste zu schaffen, die diese Nachteile behebt, Nachteile, die entstehen, wenn die Messerleiste eine Leiterplatte mit einer Abschirmung trägt oder mit einer Leiterplatte in ein Gehäuse eingebaut wird.

Die Lösung der gestellten Aufgabe ist in ihren wesentlichen Merkmalen wiedergegeben im kennzeichnenden Teil des Patentanspruches 1, hinsichtlich weiterer Ausbildungen in den Patentansprüchen 2 bis 5.

Anhand der beiliegenden Zeichnungen ist der Erfindungsgedanke näher erläutert. Es zeigen
- Fig. 1: eine teilweise geschnittene Seitenansicht durch eine bekannte Messerleiste mit Leiterplatte und Abschirmplatte,
- Fig. 2: eine der Fig. 1 entsprechende Darstellung einer erfindungsgemässen Messerleiste mit Leiterplatte und Abschirmplatte,
- Fig. 3a: eine Draufsicht auf eine Norm-Messerleiste von der Unterseite der Leiterplatte her,
- Fig. 3b: eine Draufsicht auf eine erfindungsgemässe Messerleiste von der Unterseite der Leiterplatte her,
- Fig. 4: eine Variante zu Fig. 2,
- Fig. 5: eine Draufsicht des Ausführungsbeispiels von Fig. 4 von der Kontaktseite her.

In Fig. 1 ist schematisch und im Querschnitt eine Norm-Messerleiste 1 der Bauform H nach DIN 41 612 dargestellt, die eine Leiterplatte 2 trägt. Die Einsteckposition und der Platzbedarf einer solchen Messerleiste 1 sind genormt und durch einen konsequent angewendeten Teilungsraster R festgelegt. Die dargestellte Messerleiste 1 beansprucht hier beispielsweise drei Rastereinheiten R, wie in Fig. 1 in der Seitenansicht gezeigt. Die Leiterplatte 2 ist an Lötstiften 3 angelötet. Sie trägt, beispielsweise zur Abschirmung der auf der Leiterplatte 2 befindlichen Schaltkreise, eine Abschirmplatte 5 vermittels mehrer Abstandshalter 4 (in Fig. 1 ist nur einer davon dargestellt). Der Abstand zwischen Leiterplatte 2 und Abschirmplatte 5 entspricht dem Lötbeinüberstand zuzüglich eines Toleranzabstandes T nach DIN 41 494, dergestalt dass die Abschirmplatte 5 zwangsweise in den nächsten Rasterabstand hineinragt. Die Rasterlinien mit einem Einheitsabstand von R sind in Fig. 1 gestrichelt eingetragen. Der Ueberhang der Abschirmplatte 5 zwingt zu einer Verschiebung der Messerleiste 1 um einen solchen Rasterabstand R, selbst wenn die auf der Leiterplatte 2 angebrachten Komponenten die von ihrer Bauhöhe beanspruchte Anzahl von Rasterabständen nicht voll ausschöpfen. Damit geht - verglichen mit der dichtestmöglichen Anordnung - ein Rasterabstand R verloren.

Fig. 2 zeigt einen zu Fig. 1 analogen Schnitt durch die erfindungsgemässe Lösung. Während der kontaktseitige Teil der Messerleiste 1 unverändert ist (insbesondere sind die Dimensionen, die Anzahl und die Positionen von Messerkontakten 7 der Norm entsprechend), weicht der leiterplattenseitige Teil der Messerleiste 1 von der Norm ab: Ein mit der Ziffer 6 bezeichneter Mittelteil, an dessen einer Flanke die Leiterplatte 2 angeschlagen ist und der die Kontaktfahnen enthält, die unten die Messerkontakte 7, oben die Lötstifte 3 tragen, ist gegenüber der DIN-Norm schmaler ausgeführt, im Ausführungsbeispiel gemäss Fig. 2 im wesentlichen um die Dicke der Abschirmplatte, die in Fig. 2 im wesentlichen mit dem Unterteil der Messerleiste 1 fluchtet und damit innerhalb der Normbreite der Messerleiste 1 von 3R bleibt.

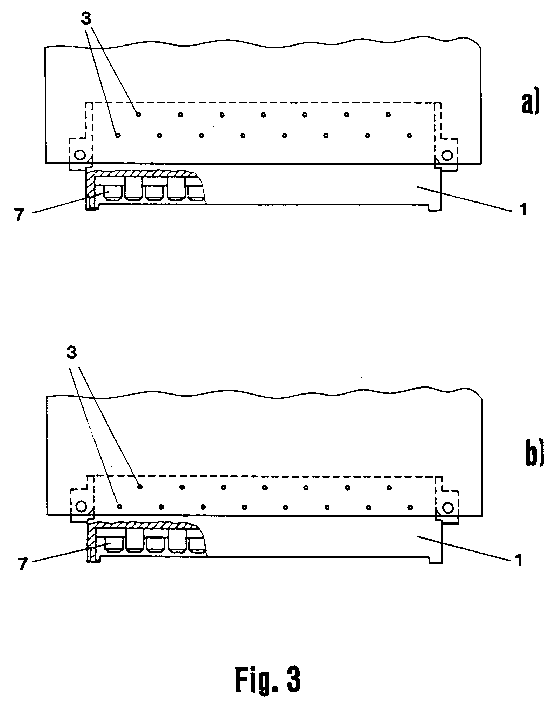

Fig. 3a zeigt die Aufsicht auf eine Norm-Messerleiste 1. Auch die Positionen der Lötstifte 3 entsprechen in diesem Ausführungsbeispiel der Norm. Obwohl ökonomische Gründe dafür sprechen können (Werkzeugkosten), ist dies im Sinne der Erfindung keineswegs zwingend. Der Sinn der Normung besteht ja darin,dass die Anschlüsse für Geräte, Komponenten und Baugruppen verschiedener Hersteller aufeinander abgestimmt sind. Hat jedoch ein Hersteller bestimmter elektronischer Baugruppen oder Funktionseinheiten besondere Bedürfnisse hinsichtlich der leiterplattenseitigen Ausführungsform einer Messerleiste, so kann das Abweichen von der Normung höchst sinnvoll sein.

Fig. 3b zeigt eine Variante zur Norm hinsichtlich der Anordnung der Lötstifte 3. Der Abstand der zwei gegeneinander versetzten Reihen von Lötstiften 3 in bezug auf die Messerkontakte 7 ist hier kürzer, als in der Norm vorgesehen. Entsprechen Grösse und Dimensionen der Leiterplatte 2 weiterhin der Norm (was zweckmässig ist), so können die Lötaugen für die Lötstifte 3 auf der Leiterplatte 2 mehr zum Rand hin verschoben werden, was den für Komponenten verfügbaren Platz auf der Leiterplatte 2 vergrössert.

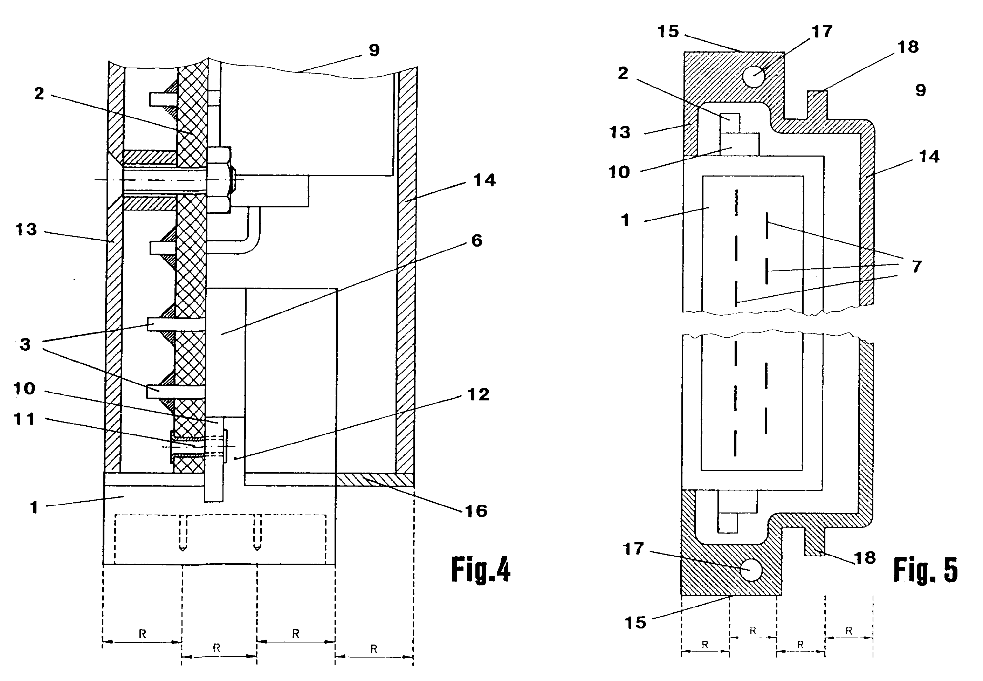

Fig. 4 zeigt die Verwendung einer Variante der erfindungsgemässen Messerleiste 1 in Verbindung mit einem metallischen Gehäuse 9, welches die Leiterplatte 2 umgibt. Die Messerleiste 1 trägt, wie auch in den Fig. 1 und 2 sichtbar, eine Schulter 10 mit einem Loch 11 zur mechanisch kraftschlüssigen Befestigung der Leiterplatte 2 mittels Schrauben oder Nieten. In Fig. 2, 3 ist diese Schulter 10 mitsamt dem Mittelteil 6 verkürzt gegenüber der Norm. Im Ausführungsbeispiel gemäss Fig. 4 ist sie durch Anbringen eines Absatzes 12 noch weiter verkürzt und passt somit in das Gehäuse 9, welches, wie in Fig 5 gezeigt, zum Beispiel aus einem flachen Rohr mit zwei ebenen und parallelen Wänden 13, 14 besteht, welche parallel zur Leiterplatte 2 verlaufen; die Wand 13 auf der Lötseite, die Wand 14 auf der Komponentenseite der Leiterplatte 2. Als Abschluss trägt das Gehäuse 9 beispielsweise einen aufgeschraubten oder aufgelöteten Deckel (nicht dargestellt), gegen die Messerleiste 1 dient ein aufschraubbarer Halbrahmen 16 als Abschluss. Selbstverständlich ist mit einer isolierenden Zwischenschicht (nicht gezeichnet) dafür gesorgt, dass weder die Wand 13 (Fig, 4, 5) noch die Abschirmplatte (Fig. 2) die Lötstellen der Leiterplatte 2 berühren können.

In diesem Ausführungsbeispiel steht das Gehäuse 9 im Sinne eines Beispiels um eine Rastereinheit R über die Messerleiste 1 hinaus. Im Sinne der Erfindung sind selbstverständlich auch 2R, 3R, nR. Wesentlich ist hier, dass das Gehäuse 9 mit seiner Wand 13 nicht über die Messerleiste 1 hinausragt, sondern dass das Uebermass über eine ganze Anzahl Rastereinheiten nR einseitig verteilt ist und als Einbauhöhe zur Verfügung steht. Der Einsatz einer erfindungsgemässen Messerleiste ist selbstverständlich auch dann sinnvoll und gegeben, wenn entweder eine Abschirmplatte 5 oder die Wand 13 eines Gehäuses 9 - bedingt durch die auf der Leiterplatte 2 oder im Gehäuse 9 enthaltenen Komponenten - einen oder mehrere ganze Rastereinheiten R auf der anderen, in Fig 4 fluchtend dargestellten Seite der Messerleiste 1 über diese hinausragen sollen und dies mit einer bekannten Messerleiste nicht ohne Raumverschwendung gelöst werden kann.

In der Fig. 5, die das gleiche Ausführungsbeispiel wie Fig. 4 nun von der Seite der Messerkontakte 7 her zeigt, ist deutlich, wie die beiden Wände 13, 14 durch zwei verhältnismässig kräftige Stege 15 verbunden sind, die je ein Loch 17 zur Befestigung des Halbrahmens 16, bzw. des (nicht gezeichneten) Deckels aufweisen. Ferner tragen die Stege 15 je eine Leiste 18, die zum Einschieben des Gehäuses 9 in den genormten Einschub dienen.

## Patentansprüche

1. Messerleiste zum Einbau in 19-Zoll Baugruppenträger, welche auf der einen Seite, der Kontakt-Seite, fünfzehn Messerkontakte (7) trägt, mit welchen sie in eine formlich entsprechende Federleiste eingesteckt werden kann, welche Messerleiste auf der anderen Seite, der Leiterplatten-Seite, fünfzehn Lötstifte (3) trägt, an welchen eine Leiterplatte (2) z.B. mit einer Metallplatte als Abschirmung angelötet werden kann, wobei die Messerleiste in ihrer Breitenausdehnung quer zu den Messerkontakten (7) und in ihrer Längenausdehnung in Richtung der Reihe der Messerkontakte (7) und in der formlichen und dimensionellen Ausgestaltung der Seite, mit welcher sie mit der Federleiste zusammengesteckt werden kann, der Bauform H nach DIN 41 612 entspricht, wobei die Messerleiste ferner auf der Leiterplatten-Seite einen Mittelteil (6) aufweist, der fünfzehn Kontaktfahnen (8) enthält, auf seiner einen Flanke als Anschlag für die Leiterplatte (2) dient, welche Kontaktfahnen (8) auf ihrer einen Seite die Messerkontakte (7), auf ihrer anderen Seite die Lötstifte (3) tragen, dadurch gekennzeichnet,
dass der Abstand zwischen dem Rand der Messerleiste und der als Anschlag für die Leiterplatte (2) dienenden Flanke des Mittelteils (6) so gross bemessen ist, dass er der Summe der Dicke einer Leiterplatte (2), der Länge des Lötbeinüberstandes nach DIN 41 494, dem Toleranzwert T nach DIN 41 494 und der Dicke einer Metallplatte entspricht.

2. Messerleiste nach Patentanspruch 1 dadurch gekennzeichnet, dass die Metallplatte eine Abschirmplatte (5) ist.

3. Messerleiste nach Patentanspruch 1 dadurch gekennzeichnet, dass die Metallplatte die Wand (13) eines Metallgehäuses (9) ist.

4. Messerleiste nach Patentanspruch 2 oder 3 dadurch gekennzeichnet, dass die Lötstifte (3) bezüglich ihres Abstandes von den Messerkontakten (7) in zwei zueinander versetzten Reihen angeordnet sind.

5. Messerleiste nach Patentanspruch 4 dadurch gekennzeichnet, dass der Abstand der Lötstifte (3) von den Messerkontakten (7) kleiner ist, als in der Norm.

## Claims

1. A male multipoint connector for installation in 19-inch module frames, bearing on the one side - the contact side - fifteen blade contacts (7) by means of which it can be plugged into a female multipoint connector of corresponding shape, the said male multipoint connector bearing on the other side - the printed-circuit board side - fifteen solder pins (3) onto which a printed-circuit board (2), for example with a metal plate as a screen, can be soldered, wherein the male multipoint connector conforms to the H design of DIN 41 612 in its width dimension transversely to the blade contacts (7), its longitudinal dimension in the direction of the row of blade contacts (7), and in the shape and dimensional arrangement of the side with which it can be connected with the female multipoint connector, wherein the male multipoint connector is further provided with a central part (6) on the printed-circuit board side which contains fifteen connecting lugs (8) and serving on one of its flanks as a stop for the printed-circuit board (2), the said connecting lugs (8) bearing the blade contacts (7) on one side and the soldered pins (3) on their other side, characterised in that the distance between the edge of the male multipoint connector and the flank of the central part (6) serving as a stop for the printed-circuit board (2) is chosen such that it corresponds to the sum of the thickness of one printed-circuit board (2), the length of the soldering post projection according to DIN 41 494, the tolerance value T according to DIN 41 494 and the thickness of one metal plate.

2. A male multipoint connector according to claim 1 characterised in that the metal plate is a screening plate (5).

3. A male multipoint connector according to claim 1 characterised in that the metal plate is the wall (13) of a metal casing (9).

4. A male multipoint connector according to claim 2 or 3, characterised in that the solder pins (3) are arranged in two rows displaced relative to each other in respect of their distance from the blade contacts (7).

5. A male multipoint connector according to claim 4, characterised in that the distance of the solder pins from the blade contacts (7) is less than in the standard.

## Revendications

1. Réglette à couteaux destinée à être montée dans des supports de bloc de 19 pouces, qui porte d'un côté, le côté contacts, quinze contacts à couteaux (7) avec lesquels elle peut être enfichée dans une réglette à ressorts de forme correspondante, et de l'autre côté, le côté carte imprimée, quinze chevilles à souder (3) au niveau desquelles une carte imprimée (2) pourvue par exemple d'une plaque métallique comme blindage peut être soudée, étant précisé que la réglette à couteaux correspond au modèle H suivant DIN 41 612 de par son extension en largeur perpendiculairement aux contacts à couteaux (7), de par son extension en longueur dans le sens de la rangée de contacts à couteaux (7) et de par la forme et les dimensions du côté avec lequel ladite réglette peut être assemblée avec la réglette à ressorts, et étant précisé que la réglette à couteaux comporte en outre, côté carte imprimée, un élément central (6) qui contient quinze pattes de contact (8) et qui sert, sur un flanc, de butée pour la carte imprimée (2), lesquelles pattes de contact (8) portent d'un côté les contacts à couteaux (7) et de l'autre les chevilles à souder (3),
caractérisée en ce que l'écartement entre le bord de la réglette à couteaux et le flanc de l'élément central (6) servant de butée pour la carte imprimée (2) est dimensionné de manière à correspondre à la somme de l'épaisseur d'une carte imprimée (2), de la longueur de la saillie des pieds de soudage selon DIN 41 494, de la tolérance T selon DIN 41 494 et de l'épaisseur d'une plaque métallique.

2. Réglette à couteaux selon la revendication 1, caractérisée en ce que la plaque métallique est une plaque de blindage (5).

3. Réglette à couteaux selon la revendication 1, caractérisée en ce que la plaque métallique est la paroi (13) d'un boîtier métallique (9).

4. Réglette à couteaux selon la revendication 2 ou 3, caractérisée en ce que les chevilles à souder (3), par rapport à leur écartement avec les contacts à couteaux (7), doivent être disposées sur deux rangées décalées.

5. Réglette à couteaux selon la revendication 4, caractérisée en ce que l'écartement entre les chevilles à souder (3) et les contacts à couteaux (7) est inférieur à la norme.
